Europäisches Patentamt

European Patent Office

Office européen des brevets

(11) Veröffentlichungsnummer: **0 199 078**
**B1**

(12) **EUROPÄISCHE PATENTSCHRIFT**

(45) Veröffentlichungstag der Patentschrift:
07.06.89

(51) Int. Cl.⁴: **H01L 23/48**

(21) Anmeldenummer: **86103595.4**

(22) Anmeldetag: **17.03.86**

(54) **Integrierte Halbleiterschaltung mit einer aus Aluminium oder einer Aluminiumlegierung bestehenden Kontaktleiterbahnebene und einer als Diffusionsbarriere wirkenden Tantalsilizidzwischenschicht.**

(30) Priorität: **11.04.85 DE 3513002**

(43) Veröffentlichungstag der Anmeldung:
**29.10.86 Patentblatt 86/44**

(45) Bekanntmachung des Hinweises auf die Patenterteilung:
**07.06.89 Patentblatt 89/23**

(84) Benannte Vertragsstaaten:
**AT BE DE FR GB IT NL SE**

(56) Entgegenhaltungen:
**EP-A- 0 132 720**
**US-A- 3 900 944**

**JOURNAL OF THE ELECTROCHEMICAL SOCIETY, Band 122, Nr. 6, Juni 1975, Seiten 769-772, Princeton, US; H.M. DAY et al.: "Reactions between the Ta-Pt-Ta-Au metallization and PtSi ohmic contacts"**

(73) Patentinhaber: **Siemens Aktiengesellschaft Berlin und München, Wittelsbacherplatz 2, D-8000 München 2(DE)**

(72) Erfinder: **Hieber, Konrad, Dr., Laubensteinstrasse 7, D-8214 Bernau(DE)**
Erfinder: **Neppl, Franz, Dr., St. Quirlnplatz 6, D-8000 München 90(DE)**
Erfinder: **Schober, Konrad, Dipl.-Phys., Annette-Kolb-Anger 13, D-8000 München 83(DE)**

**Beschreibung**

Die Erfindung betrifft eine integrierte Halbleiterschaltung mit einem aus Silizium bestehenden Substrat, in dem und auf dem die die Schaltung bildenden Elemente erzeugt sind, mit einer aus Aluminium oder aus einer Aluminium-Legierung bestehenden äußeren Kontaktleiterbahnebene, welche unter Verwendung einer als Diffusionsbarriere wirkenden, aus Tantalsilizid mit einem über der Stöchiometrie der Verbindung liegenden Tantalgehalt bestehenden Zwischenschicht mit den zu kontaktierenden Bereichen, vorzugsweise den diffundierten Siliziumbereichen der Schaltung, verbunden ist.

Integrierte Halbleiterbauelementschaltungen bestehen aus mehrlagigen Schichtstrukturen verschiedenster Materialien. Dabei kommt es zum Kontakt zwischen Metall-Metall, Metall-Isolator, Halbleiter-Isolator und Halbleiter-Metall. Zusätzlich existieren in den Schichten strukturelle Defekte, wie zum Beispiel Korngrenzen und Versetzungen. Der enge Kontakt zwischen den Schichten, die Verschiedenartigkeit der Materialien und die Gegenwart von strukturellen Defekten sind Faktoren, die den Materialtransport sowohl durch die erhöhte Temperatur, als auch durch externe Größen wie zum Beispiel elektrische Spannungen oder Stromdichten zusätzlich verstärken. Die dabei einsetzenden Materialreaktionen beeinträchtigen die Funktion der Schaltung und reduzieren ihre Zuverlässigkeit.

Da mit fortschreitender Miniaturisierung diese Probleme immer kritischer werden (es treten höhere Stromdichten auf, die Diffusionsgebiete werden flacher), müssen in der VLSI (= very large scale integrated)-Technologie Barrierenschichten eingeführt werden, die die Zuverlässigkeit der Bauelemente dadurch verbessern, daß die Reaktionen an den Kontaktflächen zwischen den verschiedenen Materialien unterbunden bzw. reduziert werden.

Eine der kritischen Grenzflächen bei Bauelementen mit Strukturen im Bereich von 1 µm und darunter sind Kontakte zwischen Silizium und einer Aluminiumlegierung, zum Beispiel Al/Si, Al/Cu, Al/Si/Cu, Al/Si/Ti. Da diese Kontakte während der Bauelementefertigung Temperaturen bis zu 500°C ausgesetzt sind, die Aluminium-Silizium-Eutektikumstemperatur jedoch nur bei 577°C liegt, ist ein Ineinanderdiffundieren der beiden Materialien über mehrere 100 nm hinweg nicht auszuschließen. Der als Al-spiking bekannte Effekt ist in dem Buch "Thin Films Interdiffusion and Reactions", John Wiley and Sons, New York 1978, auf den Seiten 15 bis 25 beschrieben. Die steigenden Stromdichten in den Kontakten induzieren zusätzlich eine Silizium-Elektromigration, die zu Kurzschlüssen zwischen Diffusionsgebieten und dem Substrat führen. Dieser Effekt ist auch durch eine Silizium-Dotierung des Aluminium-Leiterbahnmaterials nicht zu beseitigen.

Da bei VLSI-Bauelementen die Tiefe der Diffusionsgebiete im Kontaktlochbereich nur ca. 250 nm beträgt, besteht die Forderung, daß Silizium in Aluminium und Aluminium in Silizium nur im nm-Bereich diffundieren darf.

Das Problem, einen zuverlässigen Kontakt zwischen Aluminium-Legierungen und Silizium zu erhalten, wurde bis jetzt dadurch gelöst, daß die beiden Materialien durch eine Barrierenschicht voneinander getrennt werden. Die Funktionsweise solcher Barrierenschichten werden in einem Aufsatz von P. S. Ho in Thin Solid Films, 96 (1982) auf den Seiten 301 bis 316 näher beschrieben.

Aus einem Aufsatz von V. Hoffman in Solid State Technol. June 1983, Seiten 119 bis 126 und aus einem Aufsatz von S. E. Babcock aus J. Appl. Phys. 53 (10), Oct. 1982, Seiten 6898 bis 6905, ist eine Barrierenschicht aus einer Titan-Wolfram-Legierung zu entnehmen.

Weitere Materialien für Barrierenschichten sind aus fol- genden Aufsätzen bekannt:

Barrierenschicht aus reinem Wolfram → D. L. Brors et. al. Solid State Technol., April 1984, Seiten 313 bis 314,

Barrierenschicht aus Titannitrid → C. Y. Ting, M. Wittmer, Thin Solid Films <u>96</u> (1982), Seiten 327 bis 345 und M. Wittmer, J. Vac. Sci. Technol. A2, 2 (1984), Seiten 273 bis 279,

Barrierenschichten aus Zirkonnitrid → L. Krusin-Elbaum et. al. Thin Solid Films 104 (1983), Seiten 81 bis 87,

Barrierenschichten aus einer Niob-Nickel-Legierung → I. D. Wiley et. al. IEEE Transactions on Industrial Electronics, 29 (1982), Seiten 154 bis 157 und

Barrierenschichten aus einer Eisen-Wolfram-Legierung → I. Suni et. al. Thin Solid Films 107 (1983), Seiten 73 bis 80.

Mit den hier aufgezählten Materialien ist ein niederohmiger Kontakt zu $n^+$-Silizium gewährleistet, wenn eine saubere Grenzfläche, das heißt frei von Oxiden und kohlenstoffhaltigen Verunreinigungen, vorhanden ist. Der Nachteil der genannten Materialien besteht aber darin, daß für die sichere Herstellung eines niederohmigenKontaktes ein reaktives Element (sogenannter Silizidbildner) notwendig ist (für Titan, Palladium, Platin beschrieben in J. Vac. Sci. Technol. A1, 2 (1983), Seiten 459 bis 462), was bei erhöhten Temperaturen, zum Beispiel schon bei 450°C, zu einer Ausdiffusion von Silizium aus dem Kontaktloch führen kann.

In einem Aufsatz von D. B. Fraser et. al. in J. Vac. Sci. Technol., 18 (1981), Seiten 345 bis 348 ist beschrieben, daß durch die Verwendung von Tantalsilizid in Verbindung mit polykristallinem Silizium als Gatekontaktierung sehr niederohmige Kontakte erhalten werden. Sollen hier nun andere Materialien als Diffusionsbarrieren (wie oben aufgelistet) eingesetzt werden, so bedeutet dies einen vermehrten Fertigungsaufwand.

Aufgabe der Erfindung ist es, eine integrierte Halbleiterschaltung mit einer hochstabilen Kontaktmetallisierung auf der Basis von Tantalsilizid zu schaffen, bei der die drei Anforderungen an die Diffusionsbarriere, nämlich niederohmiger Kontakt zwischen Aluminium und Silizium, Verhinderung der Ausdiffusion von Silizium aus dem Kontakt und Verhinderung des Eindiffundierens von Aluminium, erfüllt werden. Außerdem muß die Herstellung der Kontaktmetallisierung in den Fertigungsprozeß für VLSI-Schaltungen leicht integrierbar sein.

Diese Aufgabe wird durch eine integrierte Halbleiterschaltung der eingangs genannten Art, die in der europäischen Patentanmeldung 0 132 720 beschrieben ist, dadurch gelöst, daß die als Barrierenschicht wirkende Tantalsilizidzwischenschicht in Richtung der zu kontaktierenden Bereiche im Substrat als auch in Richtung Kontaktleiterbahnebene durch je eine reine Tantalschicht ergänzt ist.

Gegenüber der aus der europäischen Patentanmeldung 0 132 720 bekannten Tantalsilizidschicht mit 35 Mol% Tantal in der Verbindung hat die erfindungsgemäße Schichtkombination den Vorteil, daß sie neben der Erhaltung von elektrischen Eigenschaften des Kontaktes bei der Temperatur (450°C, Wasserstoffstrom 30 Minuten) keine lokalen Defekte (zum Beispiel Löcher) in der Aluminium-Metallisierungsschicht entstehen, die auf ein lokales Eindiffundieren von Aluminium in die Tantalsilizidschicht entlang von Korngrenzen zurückzuführen sind.

Weitere Ausgestaltungen der Erfindung ergeben sich aus den Unteransprüchen.

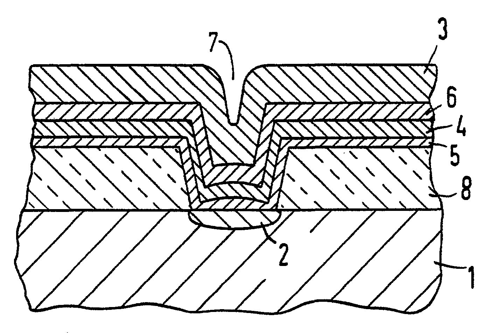

Im folgenden wird anhand der in der Zeichnung befindlichen Figur der erfindungsgemäße Schichtaufbau im Schnittbild noch näher erläutert. Dabei ist mit dem Bezugszeichen 1 das den n+- bzw. p+-dotierten flachen Bereich 2 enthaltendes Substrat und mit 8 die das Kontaktloch 7 enthaltende SiO$_2$-Schicht bezeichnet. Nach bekannten Verfahren der Halbleitertechnologie (Co-Sputtern, wobei nur zum Aufbringen der Tantalsilizid-Legierungsschicht 4 zusätzlich zum Tantaltarget ein Siliziumtarget oder ein Sintertarget mit geeigneter Zusammensetzung zerstäubt wird, Co-Dampfen oder wegen der guten Kantenbedeckung CVD-Verfahren mit Tantalhalogenid-Silan-Gemisch) wird nun der mehrlagige Schichtaufbau, bestehend aus der Kombination Tantal/Tantal-Silizium/Tantal (5, 4, 6) aufgebracht, wobei die dünne Tantalanfangslage 5 mit einer Schichtdicke von 1 bis 2 nm und 0,3 bis 0,5 nm im Kontaktloch aufgrund der sehr hohen Reaktivität des Materials bewirkt, daß die Verunreinigungen auf dem Silizium (Oxide, Kohlenstoff) gelöst werden und somit erst ein guter ohmscher Kontakt ermöglicht wird. Die geringe Schichtdicke der Tantal-Anfangslage 5 hat zur Folge, daß keine merkliche Ausdiffusion von Silizium (2) stattfindet (Bildung von TaSi$_2$). Damit auch über längere Zeit und bei höheren Temperaturen kein Silizium ausdiffundiert, wird über die dünne Tantalschicht 5 eine Tantal-Silizium-Legierungsschicht 4 (30 bis 36 Mol% Tantal, vorzugsweise 33 bis 35 Mol% Tantal) in einer Schichtdicke von 90 nm aufgebracht. Die Schichtdicke an den Flanken des Kontaktloches beträgt dann 30 nm. Die Dicke der Schicht 4 darf 200 nm nicht überschreiten, da es sonst aufgrund von inneren Spannungen in der Schicht 4 zu Abplatzungen von der Unterlage (1, 2, 8) kommt. Da Tantal durch Reaktion mit Aluminium (TaAl$_3$) das weitere Vordringen von Aluminium verhindert, wird auf die Tantal-Silizium-Legierungsschicht 4 noch eine Tantal-Deckschicht 6 von ca. 10 bis 100 nm, vorzugsweise 60 nm Dicke, aufgebracht. Auch in diesem Fall beträgt die Schichtdicke im Kontaktloch nur ca. 30 % der Ausgangsdicke.

Auf die Schichtkombination 5, 4, 6 wird eine zum Beispiel dotierte Aluminiumschicht 3 in einer Schichtdicke von 500 bis 2000 nm aufgedampft bzw. aufgestäubt und diese mit der Schichtenfolge 5, 4, 6 gemeinsam strukturiert (in der Figur nicht dargestellt).

**Patentansprüche**

1. Integrierte Halbleiterschaltung mit einem aus Silizium bestehenden Substrat (1), in dem und auf dem die die Schaltung bildenden Elemente (2) erzeugt sind, mit einer aus Aluminium oder aus einer Aluminiumlegierung bestehenden äußeren Kontaktleiterbahnebene (3), welche unter Verwendung einer als Diffusionsbarriere wirkenden, aus Tantalsilizid mit einem über der Stöchiometrie der Verbindung liegenden Tantalgehalt bestehenden Zwischenschicht (4) mit den zu kontaktierenden Bereichen, vorzugsweise den diffundierten Siliziumbereichen (2) der Schaltung verbunden ist,**dadurch gekennzeichnet**, daß die als Barrierenschicht wirkende Tantalsilizidzwischenschicht (4) in Richtung der zu kontaktierenden Bereiche (2) im Substrat (1) als auch in Richtung Kontaktleiterbahnebene (3) durch je eine reine Tantalschicht (5, 6) ergänzt ist.

2. Integrierte Halbleiterschaltung nach Anspruch 1, **dadurch gekennzeichnet**, daß die erste, auf den zu kontaktierenden Bereichen (2) befindliche Tantalschicht (5) eine Schichtdicke von kleiner 5 nm, im Kontaktloch (7) von kleiner 2 nm, und die zweite, die Tantalsilizidschicht (4) abdeckende Tantalschicht (6) eine Schichtdicke von kleiner 150 nm , im Kontaktloch kleiner 50 nm, aufweist.

3. Integrierte Halbleiterschaltung nach Anspruch 1 und 2, **gekennzeichnet durch** eine Schichtdicke der ersten Tantalschicht (5) von 1 bis 2 nm und im Kontaktloch (7) von 0,3 bis 0,5 nm, der Tantalsilizidmittelschicht (4) von kleiner 200 nm, vorzugsweise 90 nm, im Kontaktloch 30 nm, und der zweiten Tantalschicht (6) von 10 bis 100 nm, im Kontaktloch 3 bis 35 nm.

4. Integrierte Halbleiterschaltung nach mindestens einem der Ansprüche 1 bis 3,**gekennzeichnet durch** eine Tantalsilizidmittelschicht (4) zwischen den reinen Tantalschichten (5, 6) mit einem Tantalgehalt von 30 bis 36 Mol%, vorzugsweise 33 bis 35 Mol%.

5. Integrierte Halbleiterschaltung nach mindestens einem der Ansprüche 1 bis 4, **dadurch gekennzeichnet**, daß die Schichtenkombination (4, 5, 6) Tantal/Tantalsilizid/Tantal durch Kathodenzerstäubung hergestellt ist.

6. Integrierte Halbleiterschaltung nach mindestens einem der Ansprüche 1 bis 4, **dadurch gekennzeichnet**, daß die Schichtenkombination (4, 5, 6) Tantal/Tantalsilizid/Tantal durch Abscheidung aus der Gasphase (CVD = chemical vapor deposition) hergestellt ist.

**Claims**

1. Integrated semiconductor circuit having a silicon substrate (1) in which and on which the elements (2) forming the circuit are generated, having an aluminium or aluminium alloy outer contact conductor path (3) which is connected to the regions, preferably the diffused silicon regions (2), to be contacted of the circuit using an intermediate layer (4) of tantalum silicide with a tantalum content lying above the stoichiometry of the connection as a diffusion barrier, characterized in that the intermediate tantalum silicide layer (4) acting as a barrier layer is supplemented in the direction of the regions (2) to be contacted in the substrate (1) as well as in the direction of the contact conductor path (3) by in each case a pure tantalum layer (5, 6).

2. Integrated semiconductor circuit according to Claim 1, characterized in that the first tantalum layer (5) located on the regions (2) to be contacted exhibits a layer thickness of less than 5 nm, in the contact hole (7) of less than 2 nm, and the second tantalum layer (6) covering the tantalum silicide layer (4) exhibits a layer thickness of less than 150 nm, in the contact hole less than 50 nm.

3. Integrated semiconductor circuit according to Claim 1 and 2, characterized by a layer thickness of the first tantalum layer (5) of 1 to 2 nm and in the contact hole (7) from 0.3 to 0.5 nm, a thickness of the intermediate tantalum silicide layer (4) of less than 200 nm, preferbly 90 nm, in the contact hole 30 nm, and a thickness of the second tantalum layer (6) from 10 to 100 nm, in the contact hole 3 to 35 nm.

4. Integrated semiconductor circuit according to at least one of Claims 1 to 3, characterized by an intermediate tantalum silicide layer (4) between the pure tantaluem layers (5, 6) with a tantalum content of 30 to 36 mol%, preferably 33 to 35 mol%.

5. Integrated semiconductor circuit according to at least one of Claims 1 to 4, characterized in that the layer combination (4, 5, 6) of tantalum/tantalum silicide/tantalum is produced by cathode sputtering.

6. Integrated semiconductor circuit according to at least one of Claims 1 to 4, characterized in that the layer combination (4, 5, 6) of tantalum/tantalum silicide/tantalum is produced by deposition from the gas phase (CVD = chemical vapour deposition).

**Revendications**

1. Circuit intégré à semiconducteurs, comprenant un substrat (1) en silicium, dans lequel et sur lequel sont produits les éléments (2) formant le circuit, un plan extérieur de pistes conductrices de contact (3) en aluminium ou en un alliage d'aluminium, qui, avec utilisation d'une couche intermédiaire (4), servant de barrière de diffusion, en siliciure de tantale ayant une teneur en tantale supérieure à la stoechiométrie du composé, est relié aux zones à contacter, de préférence aux zones diffusées de silicium (2) du circuit, caractérisé en ce que la couche intermédiaire (4) en siliciure de tantale, servant de couche pure de tantale (5, 6) à la fois dans la direction des régions à contacter (2) du substrat (1) et dans la direction du plan des pistes conductrices de contact (3).

2. Circuit intégré à semiconducteurs suivant la revendication 1, caractérisé en ce que la première couche de tantale (5), se trouvant sur les zones à contacter (2), a une épaisseur inférieure à 5 nm et inférieure à 2 nm, dans le trou de contact (7), et la seconde couche de tantale (6), recouvrant la couche de siliciure de tantale (4), a une épaisseur inférieure à 150 nm et inférieure à 50 nm dans le trou de contact.

3. Circuit intégré à semiconducteurs suivant la revendication 1 ou 2, caractérisé par une épaisseur de la première couche de tantale (5) 1 à 2 nm et dans le trou de contact (7) de 0,3 à 0,5 nm, de la couche intermédiaire en siliciure de tantale (4) inférieure à 200 nm et de préférence de 90 nm et de 30 nm dans le trou de contact et de la seconde couche de tantale (6) de 10 à 100 nm et de 3 à 35 nm dans le trou de contact.

4. Circuit intégré à semiconducteurs suivant l'une au moins des revendications 1 à 3, caractérisé par une couche intermédiaire en siliciure de tantale (4) entre les couches pures de tantale (5, 6), ayant une teneur en tantale de 30 à 36% en mole et de préférence de 33 à 35% en mole.

5. Circuit intégré à semiconducteurs suivant l'une au moins des revendications 1 à 4, caractérisé en ce que la combinaison des couches (4, 5, 6) tantale/siliciure de tantale/tantale est fabriquée par pulvérisation cathodique.

6. Circuit intégré à semiconducteurs suivant l'une au moins des revendications 1 à 4, caractérisé en ce que la combinaison des couches (4, 5, 6) tantale/siliciure de tantale/tantale est fabriquée par dépôt en phase gazeuse (CVD = chemical vapor deposition).